# EUROPÄISCHE PATENTANMELDUNG

(11) **EP 0 825 069 A2**
(43) Veröffentlichungstag der Anmeldung: **25.02.1998**
(21) Anmeldenummer: 97113479.6
(22) Anmeldetag: 05.08.1997
(51) Int. Cl.: B60R 21/00, G01R 19/257

(54) **Verfahren zur Messwerterfassung**

(30) Priorität: 23.08.1996 DE 19634049
(71) Anmelder: TEMIC TELEFUNKEN microelectronic GmbH, 74072 Heilbronn (DE)
(72) Erfinder: Schäfer, Gerhard, Dr., 74189 Weinsberg (DE)
(74) Vertreter: Maute, Hans-Jürgen, Dipl.-Ing.

(57) **Zusammenfassung**

Die Erfindung betrifft ein Verfahren zur Meßwerterfassung an elektronischen, analogen, wenigstens eine Meßstelle aufweisende Schaltungen, insbesondere sicherheitsrelevante Schaltungen für Insassenschutzsysteme in Kraftfahrzeugen. Erfindungsgemäß werden die an den Meßstellen erzeugten elektrischen Spannungen als Meßgrößen jeweils mit einer stufenweise ansteigenden Rampenspannung verglichen, wobei die Anzahl der bis zum Erreichen des Spannungswertes der Meßgröße der jeweiligen Meßstelle benötigten Stufen als zur Meßgröße proportionale Maßeinheit vorliegt. Damit kann der Vergleich aller Meßgrößen mit der Rampenspannung gleichzeitig vorgenommen werden, wobei die Rampenspannung so ausgelegt ist, daß sie sich über den gesamten Meßbereich erstreckt.

## Beschreibung

Die Erfindung betrifft ein verfahren zur Meßwerterfassung an elektronischen, analogen, wenigstens eine Meßstelle aufweisende Schaltungen, insbesondere sicherheitsrelevante Schaltungen für Insassenschutzsysteme in Kraftfahrzeugen sowie eine Schaltungsanordnung zur Durchführung des erfindungsgemäßen Verfahrens.

Bei Insassenschutzsystemen in Kraftfahrzeugen, die personenschützende Mittel, wie Airbags, Gurtstraffer und dergleichen umfassen, ist eine sehr hohe Systemzuverlässigkeit erforderlich. Insbesondere bei sicherheitskritischen, elektronischen Schaltungen wird verlangt, daß diese stets funktionsbereit sind, und daß, falls ein Fehler auftritt, dieser sofort angezeigt wird, da der Benutzer eines Fahrzeuges sich umgehend für eine Überprüfung und Instandsetzung des Insassenschutzsystems sorgen kann.

Bei Airbag- oder Gurtstraffersystemen werden daher elektrische und/oder elektronische Komponenten des Systems während einer von der Systemelektronik durchgeführten Eigendiagnose auf ihre Funktionsfähigkeit hin überprüft. Dies erfordert die Implementierung zusätzlicher Schaltungseinheiten in den elektronischen Komponenten des Systems zur Erzeugung von Testsignalen und der Erfassung von Meßwerten.

So wird sowohl nach dem Einschalten der Bordnetzspannung des Kraftfahrzeuges ein ausführlicher Selbsttest durchgeführt, als auch zyklische Eigentests während des Kraftfahrzeugbetriebes, wobei der ausführliche Selbsttest beim Einschalten der Versorgungsspannung als Basis für die darauffolgenden zyklischen Eigentests dient.

Der Eigentest von analogen Schaltfunktionen der elektronischen Komponenten eines Insassenschutzsystems ist dabei wegen der großen Fehlervielfalt besonders kritisch. Neben der reinen Schaltfunktion sind auch Parameterfehler oder Bereichstoleranzen zu erfassen. Die Erfassung solcher Fehler setzt voraus, daß die elektronischen Komponenten solcher Insassenschutzsysteme entsprechend stimuliert werden können und zusätzlich eine analoge Meßmöglichkeit zur Verfügung steht.

In existierenden Sicherheitssystemen werden dazu relativ aufwendige A/D-Wandler verwendet, denen über analoge Multiplexer die entsprechenden Meßgrößen angeboten werden. Diese Meßgröße wird dann in einen digitalen Wert umgesetzt und in einem digitalen Rechenwerk (Mikroprozessor) ausgewertet.

Hierbei übernimmt das digitale Rechenwerk in der Regel auch die Steuerung der Stimulierung der elektronischen Komponenten zur Erzeugung von entsprechenden Meßgrößen sowie die Steuerung der Multiplexer.

Neben dem Aufwand für die analogen Multiplexer muß meist noch ein nicht unerheblicher Schaltungsteil für die Signalanpassung an den Eingangsbereich des A/D-Wandlers implementiert werden. Einflüsse durch unterschiedliche Betriebstemperaturen oder Einkopplungen von Störsignalen anderer Baugruppen sind, besonders bei der Übertragung der Signale über die einzelnen Komponenten hinaus, ebenfalls zu berücksichtigen.

Die Aufgabe der vorliegenden Erfindung besteht daher darin, ein einfaches Verfahren zur Meßwerterfassung an elektronischen, analogen, wenigstens eine Meßstelle aufweisende Schaltungen, insbesondere sicherheitskritische Schaltungen für Insassenschutzsysteme in Kraftfahrzeugen, anzugeben, das eine kostengünstige Realisierung erlaubt und gleichzeitig die sichere Durchführung von Diagnosefunktionen, insbesondere Selbsttests ermöglicht.

Darüber hinaus soll auch eine Schaltungsanordnung zur Durchführung dieses erfindungsgemäßen Verfahrens angegeben werden.

Die Lösung der erstgenannten Aufgabe ist durch die Merkmale des Patentanspruches 1 gegeben, wonach die an den Meßstellen erzeugten elektrischen Spannungen als Meßgrößen mit einer stufenweise ansteigenden Rampenspannung verglichen werden, und die Anzahl der bis zum Erreichen des Spannungswertes der Meßgröße der jeweiligen Meßstelle benötigten Stufen als Maßeinheit dient, d. h. ein direktes Maß für den Meßwert der Meßgröße darstellt.

Gemäß der Erfindung wird somit die Rampenspannung mit allen Meßgrößen verglichen und dabei die Anzahl der Spannungsstufen festgestellt, die erforderlich sind, um den Meßwert der jeweiligen Meßgröße mit der Rampenspannung zu erreichen. Dabei wird der Spannungsbereich dieser Rampenspannung derart gewählt, daß sie den gesamten erforderlichen Meßbereich durchläuft. Dieses erfindungsgemäße Verfahren ist sehr einfach und kann mit kostengünstigen und standardisierten Komponenten realisiert werden, beispielsweise mit Einsatz einfachster Komparatoren und Rampengeneratoren.

Bei einer besonders vorteilhaften Ausführungsform des erfindungsgemäßen Verfahrens wird zur Kalibrierung der Maßeinheit die Rampenspannung mit einer Referenzspannung verglichen. Damit können gleichzeitig alle Meßmittel mit nur einem einzigen Referenzsignal kalibriert werden, so daß alle Meßfehler erfaßt werden und insbesondere keine Temperaturkompensation erforderlich ist. Die Ermittlung des Meßfehlers erfolgt somit vor jeder Messung und kann damit in der Auswertung des Meßwertes berücksichtigt werden.

Eine Messung besteht vorzugsweise aus einem Meßzyklus mit mehreren Schritten, beginnend mit der Stimulierung der Schaltung zur Erzeugung einer Meßgröße an einer ausgewählten Meßstelle, anschließende Erzeugung der Rampenspannung vom Wert 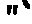 0" beginnend um eine bestimmte Spannungsstufe und anschließender Vergleich dieser Rampenspannung mit der Meßgröße. Falls die Rampenspannung kleiner als die Meßgröße ist, wird die Rampenspannung um eine weitere Spannungsstufe erhöht und gleichzeitig die Anzahl der Spannungsstufen bestimmt, um anschließend den Vergleichsvorgang zu wiederholen. Falls jedoch die Rampenspannung die Meßgröße übersteigt, wird der Meßvorgang beendet und die Anzahl der Spannungsstufen ausgewertet.

Zur Kalibrierung der Maßeinheit werden die gleichen Schritte wie bei dem zuvor beschriebenen Meßzyklus ausgeführt, wobei jedoch anstelle der Stimulierung der Schaltung zur Erzeugung einer Meßgröße die Referenzspannung erzeugt wird.

Schließlich kann bei einer letzten Ausführungsform des erfindungsgemäßen Verfahrens die Auswertung der Anzahl der Spannungsstufen, die mit einem Meßzyklus oder mit dem Kalibrierungsverfahren ermittelt wurden, softwaremäßig mittels eines Mikroprozessors durchgeführt werden.

Eine Schaltungsanordnung zur Durchführung des erfindungsgemäßen Verfahrens erfordert einen getakteten Rampengenerator zur Erzeugung der Rampenspannung sowie für jede Meßgröße einen Komparator, der den Vergleich der Meßgröße mit der Rampenspannung durchführt. Ferner ist zur Kalibrierung der Maßeinheit lediglich eine einzige Referenzspannungsquelle und ein Komparator erforderlich, der die von der Referenzspannungsquelle erzeugte Referenzspannung mit der Rampenspannung vergleicht.

Schließlich kann zur Ermittlung der Anzahl der Spannungsstufen ein Pulszähler vorgesehen werden, der zusammen mit dem Rampengenerator von einem Mikroprozessor angesteuert wird. Alternativ kann die Anzahl der Spannungsstufen auch in einem Mikroprozessor gespeichert werden.

Im folgenden soll das erfindungsgemäße Verfahren anhand von Ausführungsbeispielen im Zusammenhang mit den Zeichnungen dargestellt und erläutert werden. Es zeigen:
- Figur 1: ein Blockschaltbild zur Durchführung des erfindungsgemäßen Verfahrens,
- Figur 2: ein modifiziertes Blockschaltbild gemäß dem Ausführungsbeispiel nach Figur 1,
- Figur 3: ein Schaltbild eines Rampengenerators,
- Figur 4: ein Spannungs-Zeitdiagramm einer von dem Rampengenerator gemäß Figur 3 erzeugten Rampenspannung,
- Figur 5: ein Ablaufdiagramm zur Durchführung eines Meßzykluses gemäß der Erfindung,
- Figur 6: ein Ablaufdiagramm zur Durchführung einer Kalibrierung der Maßeinheit gemäß der Erfindung,
- Figur 7: ein Schaltbild einer Auslöseschaltung mit einer Endstufe zur Auslösung eines Insassenschutzsystems mit zugehörigen Meßstellen, und
- Figur 8: eine Meßschaltung zur Messung des Widerstandes einer für die Auslösung eines Sicherheitssystems erforderlichen Auslösemittels, insbesondere einer Zündpille.

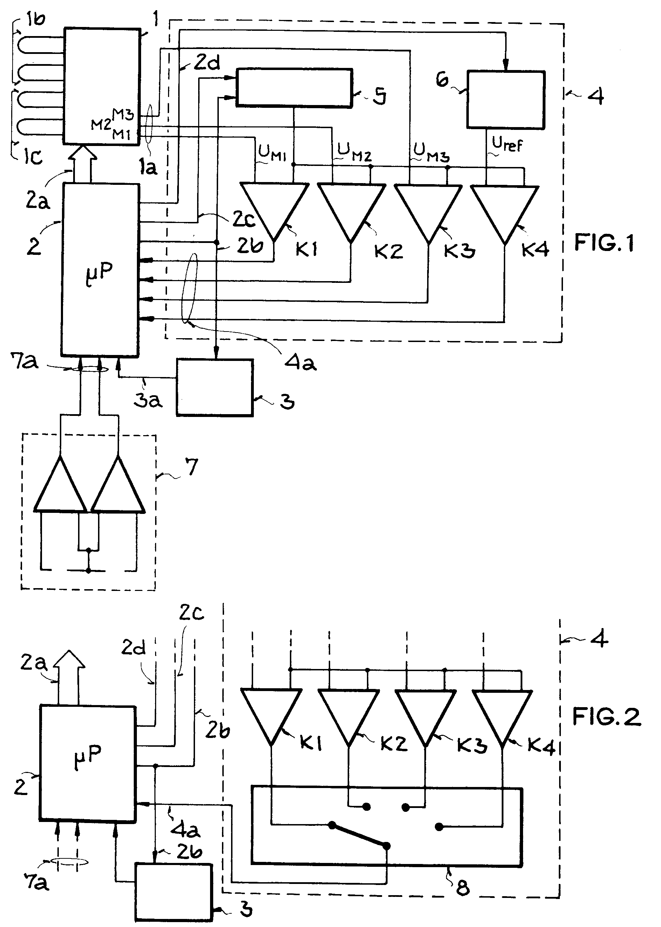

Das Blockschaltbild nach Figur 1 eines Insassenschutzsystems mit Airbags und Gurtstraffern enthält als zentrale Systemsteuereinheit einen Mikroprozessor 2, eine von diesem über eine Leitung 2a angesteuerte Auslöseschaltung 1, die die entsprechenden Auslösemittel, wie beispielsweise die Zündpillen für die Airbags 1b und die Gurtstraffer 1c über zugehörige Endstufen ansteuert, die zur Steuerung des durch die Zündpillen fliegenden Auslösestromes entsprechende Endstufentransistoren aufweisen. Die Auslösung dieser Schutzmittel 1b und 1c erfolgt durch den Mikroprozessor 2 in Abhängigkeit der von einer Sensoreinheit 7 erzeugten Beschleunigungssignale, die über Leitungen 7d diesem Mikroprozessor 2 zur Auswertung zugeführt werden. Diese Sensoreinheit 7 enthält zwei Beschleunigungssensoren, deren Beschleunigungssignale vor einer Weiterleitung an den Mikroprozessor 2 jeweils verstärkt werden.

Auch die Auslösung entsprechender Diagnosefunktionen in der Auslöseschaltung 1 wird durch den Mikroprozessor 2 eingeleitet. Hierzu existieren auf dieser Auslöseschaltung 1 Meßstellen M1, M2 und M3, an denen Meßspannungen erzeugt werden, die über eine Leitung 1a einer Meßschaltung 4 zur Durchführung des erfindungsgemäßen Verfahrens zugeführt werden.

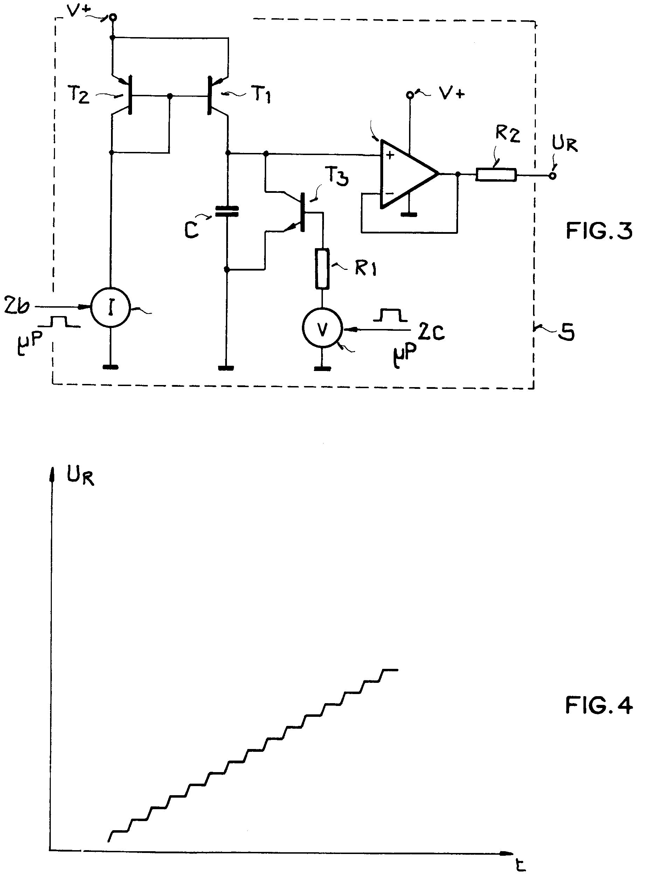

Hierzu enthält diese Meßschaltung 4 einen Rampengenerator 5, der mit jeweils einem Eingang von vier Komparatoren K1, K2, K3 und K4 verbunden ist. Dieser Rampengenerator 5 erzeugt eine stufen- bzw. treppenförmige Rampenspannung U_{R}, wie sie in dem Zeit-Spannungsdiagramm gemäß Figur 4 dargestellt ist. Ferner enthält die Meßschaltung 4 eine Referenzspannungsquelle 6 zur Erzeugung einer Referenzspannung U_{ref} von beispielsweise 1,205 V, die an den zweiten Eingang des Komparators K4 angelegt wird. An die zweiten Eingänge der verbleibenden Komparatoren K1, K2 und K3 wird jeweils die an den Meßstellen M1, M2, M3 erzeugten Meßgrößen U_{M1}, U_{M2} und U_{M3} zugeführt.

Die Ausgänge der Komparatoren K1 bis K4 führen jeweils auf einen Eingang des Mikroprozessors 2 und sind mit dem Bezugszeichen 4a bezeichnet. Dieser Mikroprozessor 2 setzt den Rampengenerator 5 über eine Leitung 2c zurück. Eine weitere Leitung 2b dient dazu, den Rampengenerator 5 taktweise anzusteuern, um die treppenförmige Rampenspannung zu erzeugen. Gleichzeitig werden die auf der Leitung 2b liegenden Taktimpulse einem Impulszähler 3 zugeführt, dessen Zählerstand dem Mikroprozessor 2 über eine Leitung 3a mitgeteilt wird. Alternativ kann die Anzahl der Taktimpulse in dem Mikroprozessor 2 gespeichert werden, so daß der Impulszähler 3 enthalten kann. Schließlich erzeugt der Mikroprozessor 2 über eine Leitung 2d ein Steuersignal für die Referenzspannungsquelle 6.

Die von dem Rampengenerator 5 erzeugte treppenförmig ansteigende Rampenspannung U_{R} wird mittels der Komparatoren K1 bis K4 mit der an den Meßstellen M1, M2, M3 zur Verfügung gestellten Meßgröße U_{M1}, U_{M2} und U_{M3}, einem Spannungssignal, verglichen. Wird die Rampenspannung U_{R} größer als die Meßgröße U_{M1}, U_{M2} und U_{M3}, schaltet der Ausgang des betreffenden Komparators K1, K2 oder K3 seinen Ausgang auf einen anderen Spannungspegel um, der den Mikroprozessor 2 veranlaßt die für das Umschalten des Komparators erforderliche Anzahl an Spannungsstufen auszuwerten. Durchläuft die Rampenspannung den gesamten Meßbereich (... V bis ... V) der Meßgrößen U_{M1}, U_{M2} und U_{M3}, so schalten im Verlauf des Anstieges der Rampenspannung U_{R} alle Komparatoren K1 bis K3 um, so daß mit der Umschaltung des letzten Komparators der Mikroprozessor 2 die Messung beenden kann. Da die Ausgänge der Komparatoren K1 bis K3 parallel auf den Mikroprozessor 2 geführt sind, kann die Auswertung der für jede Meßgröße maßgeblichen Anzahl der Spannungsstufen parallel erfolgen. Dies ist jedoch nur dann möglich, wenn die Anzahl der Eingänge des verwendeten Mikroprozessors 2 eine ausreichende Anzahl an Eingängen aufweist.

Bei einer begrenzten Anzahl der Eingänge des Mikroprozessors 2 können die Ausgänge der Komparatoren K1 bis K3 einem Multiplexer 8 zugeführt werden, der die Ausgänge der Komparatoren einzeln dem Mikroprozessor 2 zuführt, wie dies in Figur 2 dargestellt ist. Da in der Regel die Meßschaltung 4 zusammen mit der Auslöseschaltung 1 auf einem einzigen integrierten Schaltkreis implementiert wird, ergibt sich der Vorteil, daß für den Mikroprozessor 2 nur ein einziger Eingangspin erforderlich ist.

Ein in den Ausführungsbeispielen gemäß den Figuren 1 und 2 verwendeter Rampengenerator 5 zeigt Figur 3, bei dem ein Kondensator C über einen aus zwei Transistoren T1 und T2 aufgebauten Stromspiegel und einer steuerbaren Stromquelle I stufenweise geladen wird. Die steuerbare Stromquelle I wird pulsweise über die Leitung 2b des Mikroprozessors 2 angesteuert, so daß sich die Ladespannung an dem Kondensator C stufenförmig erhöht. So wird beispielsweise mit den der Stromquelle I zugeführten 15 Impulsen die Rampenspannung U_{R} gemäß Figur 4 erzeugt.

Um den Rampengenerator 5 zurückzusetzen, wird der Kondensator C mit der Emitter-Kollektor-Strecke eines Transistors T3 überbrückt. Die Basis dieses Transistors T3 liegt über die Serienschaltung eines Widerstandes R1 und einer steuerbaren Spannungsquelle V auf dem Bezugspotential der Schaltung. Wird diese steuerbare Spannungsquelle V über die Leitung 2c des Mikroprozessors 2 eingeschaltet, erfolgt über den durchgesteuerten Transistor T3 eine Entladung des Kondensators C. Die Ladespannung des Kondensators C wird über einen als Spannungsfolger geschalteten Operationsverstärker OP unter Pufferung der Kondensatorspannung über einen Widerstand R2 auf den Ausgang des Rampengenerators geführt, an dem die Rampenspannung U_{R} zur Verfügung steht.

Der Mikroprozessor 2 führt außerdem eine Kalibrierung der Maßeinheit vor, indem die von der Referenzspannungsquelle 6 erzeugte Referenzspannung U_{ref} ebenfalls mit der von dem Rampengenerator 5 erzeugten Rampenspannung U_{R} verglichen wird und die bei Änderung des Ausgangsspannungspeges des Komparators K4 festgestellte Anzahl der hierfür erforderlichen Spannungsstufen von dem Mikroprozessor 2 ausgewertet wird. Damit wird eine eindeutige Zuordnung zwischen dem Wert der Referenzspannung U_{ref} und der hierfür erforderlichen Anzahl von Spannungsstufen hergestellt. Damit werden alle Meßfehler durch eine solche Kalibrierung erfaßt, insbesondere ist keine Temperaturkompensation erforderlich.

Durch die Einbindung der Referenzspannung U_{ref} in den Kalibrierungsvorgang werden nicht nur Fehler durch den Temperaturgang, sondern gleichfalls Toleranzen der Kapazität des Kondensators C des Rampengenerators 5, Abweichungen des Ladestroms dieses Kondensators C vom Sollwert und ähnliche Fehler eliminiert. Die Genauigkeit einer Messung hängt lediglich von der Pulsdauer des der Stromquelle I zugeführten Impulssignales ab, wobei jedoch solche Impulse leicht aus einer vorhandenen Quarzzeitbasis ableitbar sind, womit eine hohe Meßgenauigkeit realisierbar ist. Abweichungen im Ladestrom des Kondensators C und in dessen Kapazitätswert führen daher lediglich zu einer veränderten Auflösung, aber nicht zu einem höheren Fehler.

Eine realistische Auflösung könnte bei 100 bis 200 Impulsen, d. h. also zwischen 100 und 200 Spannungsstufen pro Volt liegen. Da die meisten Mikroprozessoren Register mit 16 Bit Wortbreite aufweisen, lassen sich mit ihnen prinzipiell auch 16-Bit-auflösende Zähler bauen. So wäre es möglich, Meßwerte mit einer recht hohen Auflösung zu erfassen.

So kann beispielsweise eine Auflösung von 100 Impulsen/Volt, das entspricht einer Auflösung von 10 mV mit einem Kondensator C von 10 nF, einem Ladestrom von 2 µA, einer Impulsfrequenz von 10 kHz und einem Impuls-Pausen-Verhältnis von 1:1 erreicht werden.

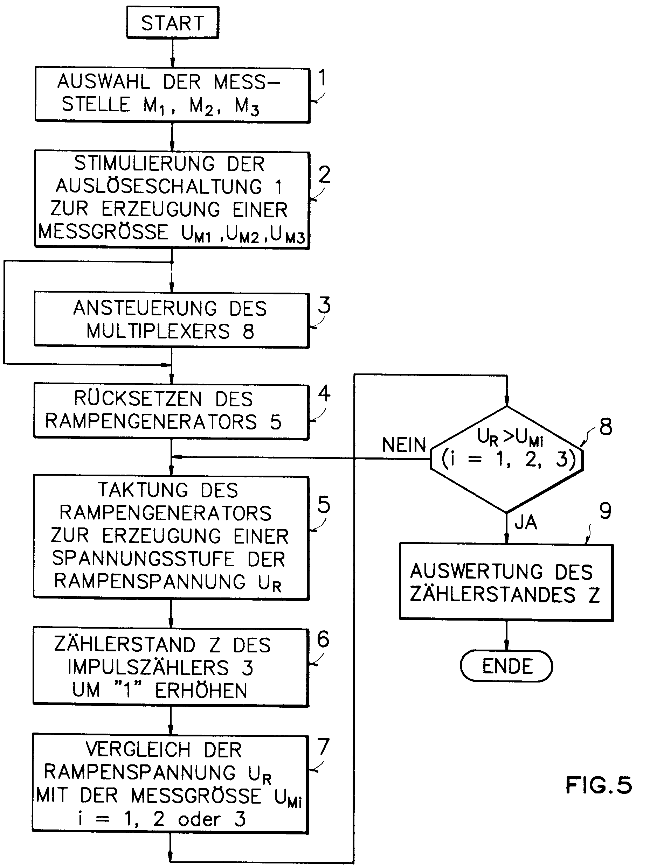

Anhand des Flußdiagrammes gemäß Figur 5 soll beispielhaft ein von dem Mikroprozessor 2 gemäß Figur 1 bzw. 2 durchzuführender Meßvorgang beschrieben werden. Nach dem Start des Programms wird zunächst über den Mikroprozessor 2 eine Auswahl der Meßstelle in der Auslöseschaltung 1 getroffen (Schritt 1). Anschließend erfolgt in Schritt 2 eine Stimulierung der Auslöseschaltung 1 derart, daß an der ausgewählten Meßstelle M1, M2 oder M3 eine Meßgröße U_{M1}, U_{M2} oder U_{M3} erzeugt wird.

Falls ein Multiplexer 8 vorgesehen ist (vgl. Figur 2) wird mit Schritt 3 dieser so angesteuert, daß das Ausgangssignal des entsprechenden Komparators K1, K2 oder K3 auf den Mikroprozessor geführt wird.

Ansonsten führt der Mikroprozessor 2 den Schritt 4 durch, mit dem der Rampengenerator 5 über die Leitung 2c zurückgesetzt wird. Anschließend wird dieser Rampengenerator 5 mit einem einzigen Impuls getaktet, so daß die erste Spannungsstufe der Rampenspannung U_{R} erzeugt wird. Gleichzeitig wird dieser Impuls auch dem Zähler 3 zugeführt, so daß dessen Zählerstand Z um 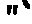 1" erhöht wird.

Im nächsten Schritt 7 erfolgt der Vergleich der Rampenspannung U_{R} mit der Meßgröße U_{Mi} an dem entsprechenden Komparator Ki, mit der Folge, daß bei Überschreitung der Rampenspannung U_{R} des Meßwertes U_{Mi} (vgl. Schritt 8) im nachfolgenden Schritt 9 eine Auswertung des Zählerstandes Z des Impulszählers 3 ausgeführt wird. Diese vor dem Mikroprozessor 2 durchgeführte Auswertung führt zur Bestimmung des Meßwertes.

Falls jedoch gemäß Schritt 8 der Meßwert U_{Mi} von der Rampenspannung U_{R} noch nicht erreicht ist, erfolgt ein Rücksprung auf den Schritt 5.

Anstatt der Auswahl einer einzigen Meßstelle (vgl. Schritt 1) können auch mehrere Meßstellen gleichzeitig ausgewählt werden, die dann auch aufgrund der Stimulierung der Auslöseschaltung 1 gleichzeitig entsprechende Meßgrößen erzeugen.

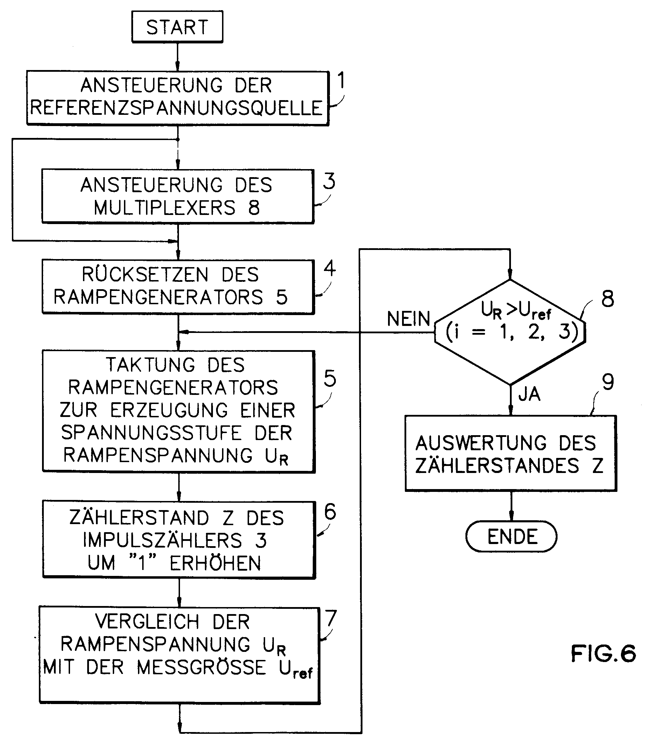

Die Kalibrierungsfunktion mittels der Referenzspannungsquelle 6 und des zugehörigen Komparators K4 entspricht dem Flußdiagramm gemäß Figur 6. Dieses Flußdiagramm entspricht im wesentlichen demjenigen nach Figur 5, mit dem Unterschied, daß Schritt 1 und 2 aus Figur 5 durch den Vorgang 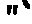 Ansteuerung der Referenzspannungsquelle 6" ersetzt wird. Darüber hinaus erfolgt der Vergleich der Rampenspannung U_{R} mit der Referenzspannung U_{ref} mit Schritt 7. Die Auswertung des Zählerstandes Z gemäß Schritt 9 führt zur Bestimmung der Kalibrierungsfaktoren.

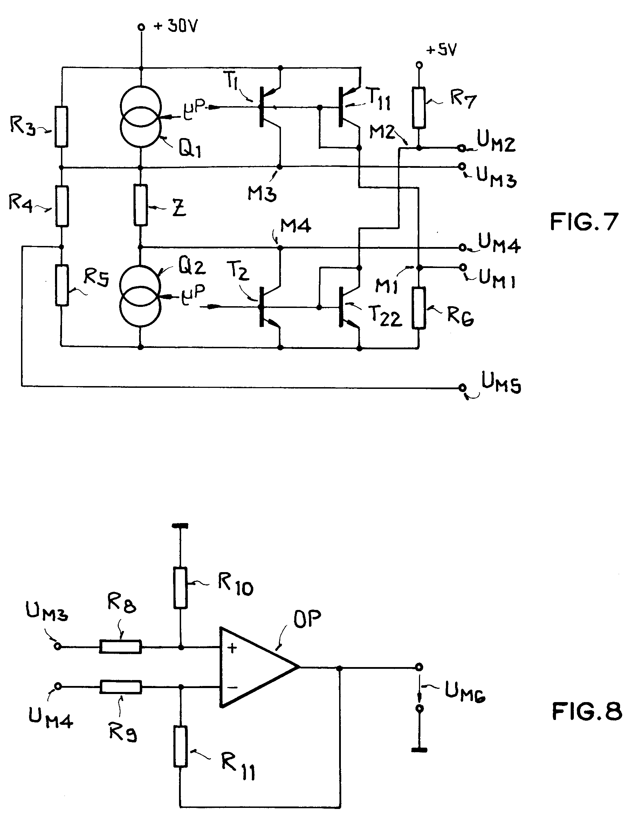

Die beispielhaft in Figur 7 dargestellte Auslöseschaltung enthält ein Auslösemittel Z, beispielsweise eine Zündpille zur Auslösung eines Airbags oder eines Gurtstraffers, das zusammen mit einem Endstufentransistor T1 als High-Side-Schalter und einem weiteren Endstufentransistor T2 als Low-Side-Schalter den Auslösestromkreis bilden. Diese beiden Endstufentransistoren T1 und T2 werden von dem Mikroprozessor 2 (vgl. Figuren 1 und 2) im Auslösefall derart angesteuert, daß ein durch das Zündmittel Z fließender Auslösestrom zur Auslösung führt. Der Einfachheit halber enthält diese Auslöseschaltung lediglich eine Endstufe mit zugehörigem Zündmittel Z gegenüber der Auslöseschaltung 1 gemäß Figur 1 oder 2, wo vier Endstufen vorgesehen sind.

Um die in der Endstufe erforderlichen Diagnosefunktionen durchzuführen, enthält diese Auslöseschaltung mehrere Meßstellen M1 bis M5, die zusätzliche Elemente erfordern.

So ist ein als Diode geschalteter Transistor T11 vorgesehen, der zusammen mit dem Endstufentransistor T1 einen Stromspiegel T1/T11 bildet. Der Ausgang dieses Stromspiegels, der Kollektor-Anschluß des Transistor T11, bildet eine erste Meßstelle M1, die über einen Widerstand R6 mit dem Bezugspotential der Schaltung verbunden ist.

In gleicher Weise bildet ein weiterer ebenfalls als Diode geschalteter Transistor T22 zusammen mit dem Endstufentransistor T2 ebenfalls einen Stromspiegel T2/T22, dessen Ausgang, die Kollektor-Elektrode des Transistors T22, eine zweite Meßstelle M2 bildet, die über einen entsprechenden Widerstand R7 an + 5 V gelegt ist.

Im weiteren ist sowohl parallel zum Endstufentransistor T1 als auch zum Endstufentransistor T2 jeweils eine von dem Mikroprozessor steuerbare 20 mA-Stromquelle Q1 und Q2 geschaltet. Der jeweilige Verbindungspunkt zum Zündmittel Z bildet jeweils eine dritte bzw. vierte Meßstelle M3 bzw. M4.

Schließlich ist parallel zur Stromquelle Q1 ein Widerstand R3 und parallel zur Stromquelle Q2 ein Spannungsteiler R4/R5 aus zwei Widerständen R4 und R5 geschaltet. An diesem Spannungsteiler entsteht eine fünfte Meßstelle M5.

Diese Meßstellen M1 bis M5 liefern bei entsprechender Ansteuerung der Endstufentransistoren T1 und T2 bzw. der Stromquellen Q1 und Q2 Meßsignale U_{M1} bis U_{M5}.

Im einzelnen werden folgende Prüfungen vorgenommen.

Zur Prüfung des Endstufentransistors T1 wird die Stromquelle Q2 und dieser Endstufentransistor T1 von dem Mikroprozessor µP eingeschaltet. Somit fließt sowohl durch das Zündmittel Z als auch durch den Endstufentransistor T1 ein Strom von 20 mA, der natürlich das Zündmittel Z nicht auslösen kann. Die Meßstelle M3 liefert somit die Sättigungsspannung U_{M3} des Endstufentransistors T1, wobei der durch diesen Transistor fließende Strom von 20 mA indirekt als Spannungsabfall U_{M1} über den Widerstand R6 gemessen werden kann.

In gleicher Weise wird der Endstufentransistor T2 überprüft, indem von dem Mikroprozessor µP dieser Transistor T2 als auch die Stromquelle Q1 eingeschaltet wird, um an der vierten Meßstelle M4 die Sättigungsspannung U_{M4} dieses Transistors T2 und den diesen durchfließenden Strom über den Spannungsabfall U_{M2} über dem Widerstand R7 messen zu können.

Mit der Meßstelle M5 kann die Potentialmitte der Spannungsversorgung (30 V) der Auslöseschaltung überprüft werden, indem sowohl die Stromquellen Q1 und Q2 als auch die Endstufentransistoren T1 und T2 in den sperrenden Zustand gesteuert werden. Mit dem durch die Widerstände R3 und R4 bzw. R5 gebildeten Spannungsteiler, der hochohmig ausgelegt ist, wird das Potential, auf dem sich das Zündmittel Z befindet, auf ca. 3 V festgelegt. Damit soll ein evtl. Masseschluß, der in der Kabelverbindung von der Auslöseschaltung zum Zündmittel Z auftreten könnte, mit der Meßgröße U_{M5} detektiert werden.

Somit werden bei den Endstufentransistoren T1 und T2 der Strom als auch die Sättigungsspannung gemessen, wobei die Sättigungsspannungen bei Verwendung von Bipolartransistoren in Dreifach-Darlington-Ausführung bei 1,4 V liegen. Der durch diese Endstufentransistoren fließende Strom wird dagegen als Spannungsabfall an einem Widerstand R6 bzw. R7 gemessen. Dabei werden die Werte dieser Widerstände so gewählt, daß ein Spannungsabfall im Bereich um 1 V erzeugt wird. Bei einer 10 mV-Auflösung werden dann beide Meßgrößen mit ausreichender Präzision erfaßt.

Zur Messung des Widerstandes des Zündmittels Z werden die beiden Meßgrößen U_{M3} und U_{M4}, deren Spannungsdifferenz den Spannungsabfall über diesem Zündmittel Z darstellt, einer Subtrahierschaltung gemäß Figur 8 zugeführt, wo diese Spannungsdifferenz verstärkt und anschließend als Meßgröße U_{M6} direkt einem Meßeingang der Meßschaltung 4 zugeführt werden kann.

Diese Subtrahierschaltung gemäß Figur 8 enthält einen Operationsverstärker OP, dessen nicht-invertierender Eingang einerseits über einen Widerstand R10 mit dem Bezugspotential der Schaltung und andererseits über einen Widerstand R8 mit der Meßstelle M3 verbunden wird. Der invertierende Eingang dagegen, ist sowohl über einen Widerstand R9 an die Meßstelle M4 als auch über einen Widerstand R11 an den Ausgang angeschlossen, an dem sich der verstärkte Spannungsabfall U_{M6} über dem Zündmittel Z abgreifen läßt.

Weisen die Widerstände R10 und R11 jeweils den 30fachen Widerstandswert der Widerstände R8 und R9 mit gleichem Widerstandswert auf, ergibt sich ein Verstärkungsfaktor 30. Mit einem Widerstandswert der Zündpille von 1,6 bis 6,6 Ω und einem Strom von 20 mA ergibt sich ein Spannungsabfall über der Zündpille von 32 mV bis 132 mV, der zu einer Meßgröße U_{M6} am Ausgang der Subtrahierschaltung führt, die zwischen 0,96 V und 3,96 V liegt. Diese Werte liegen ideal im Meßbereich der von dem Rampengenerator 6 erzeugten Rampenspannung, wobei die Auflösung von 100 Spannungsstufen pro Volt etwa 16 mΩ entspricht.

Schließlich müssen noch die sicherheitsrelevanten Betriebsspannungen überprüft werden. Hierzu wird beispielsweise die Spannungsversorgung von + 5 V mit einem aus gleich großen Widerständen bestehenden Spannungsteiler auf 2,5 V heruntergeteilt und liegt somit im Spannungsbereich des Rampengenerators. In ähnlicher Weise können mit einem entsprechend dimensionierten Spannungsteiler auch höhere Betriebsspannungen oder die Ladespannungen von Autarkiekondensatoren gemessen werden.

Um im Falle eines Unfalles, bei dem eine Störung des Bordnetzes des Kraftfahrzeuges auftreten kann, die Spannungsversorgung der Auslöseelektronik sicherzustellen, sind sogenannte Autarkiekondensatoren vorgesehen, die ausreichende Energie enthalten, um in jedem Fall die Zündmittel, beispielsweise die Zündpillen zum Auslösen zu bringen. Da man eine Alterung dieser Autarkiekondensatoren und damit eine Verringerung ihrer Kapazität nicht ausschließen kann, muß deren Speicherfähigkeit ständig überprüft werden, wobei diese Überprüfung in der Regel jedoch nur beim Anlassen des Motors durchgeführt wird.

Hierzu werden die in Figur 7 beschriebenen 20 mA-Stromquellen Q1 oder Q2 benutzt, um eine pulsförmige Ladung auf diese Autarkiekondensatoren zu bringen. Die mit dieser pulsförmigen Ladung bewirkte Änderung der Ladespannung dient als Meßgröße und wird ebenfalls der Meßschaltung 4 zugeführt.

Wird ein Kondensator mit 4700 µF mit einem Strom von 20 mA geladen, so ändert sich dessen Ladespannung um 4,25 V pro Sekunde. Eine Meßdauer von 0,5 s genügt daher, um dessen Kapazität mit ausreichender Genauigkeit bestimmen zu können.

Die Anwendung dieses erfindungsgemäßen Verfahrens zur Meßwerterfassung beschränkt sich nicht nur auf analoge Schaltungen im Zusammenhang mit Insassenschutzsysteme für Kraftfahrzeuge, sondern kann auch darüber hinaus in anderen Gebieten, beispielsweise Schaltungen für Motorsteuerungen eingesetzt werden.

## Patentansprüche

1. Verfahren zur Meßwerterfassung an elektrischen, analogen, wenigstens eine Meßstelle aufweisende Schaltungen, insbesondere sicherheitskritische, elektronische Schaltungen für Insassenschutzsysteme in Kraftfahrzeugen, indem die an den Meßstellen (M1, M2, M3) erzeugten elektrischen Spannungen als Meßgrößen (U_{M1}, U_{M2}, U_{M3}) jeweils mit einer stufenweise ansteigenden Rampenspannung (U_{R}) verglichen werden und die Anzahl der bis zum Erreichen des Spannungswertes der Meßgröße (U_{M1}, U_{M2}, U_{M3}) der jeweiligen Meßstelle (M1, M2, M3) benötigten Spannungsstufen als Maßeinheit dient.

2. Verfahren nach Anspruch 1, wobei zur Kalibrierung der Maßeinheit die Rampenspannung (U_{R}) mit einer Referenzspannung (U_{ref}) verglichen wird.

3. Verfahren nach Anspruch 1 oder 2, wobei die Meßwerterfassung folgende Schritte umfaßt:
a) Stimulierung der Schaltung (1) zur Erzeugung einer oder mehrerer Meßgröße(n) (U_{M1}, U_{M2}, U_{M3}) an einer oder mehreren ausgewählten Meßstelle(n) (M1, M2, M3),
b) Erzeugung der Rampenspannung (U_{R}) mit einer ersten Spannungsstufe,
c) Vergleich der Rampenspannung (U_{R}) mit der bzw. den Meßgröße(n) (U_{M1}, U_{M2}, U_{M3}),
d) Erhöhung der Rampenspannung (U_{R}) um eine weitere Spannungsstufe, falls die Rampenspannung (U_{R}) kleiner als die Meßgröße(n) (U_{M1}, U_{M2}, U_{M3}) ist (sind) und Bestimmung der Anzahl der Spannungsstufen und Durchführung des Schrittes c),
e) Beendigung des Meßzykluses und Auswertung der Anzahl der Spannungsstufen, falls die Rampenspannung (U_{R}) größer als die Meßgröße(n) (U_{M1}, U_{M2}, U_{M3}) ist.

4. Verfahren nach einem der Ansprüche 2 oder 3, wobei zur Kalibrierung der Maßeinheit folgende Schritte durchgeführt werden:
a) Erzeugung der Referenzspannung (U_{ref}),
b) Erzeugung der Rampenspannung (U_{R}) mit einer einzigen Spannungsstufe,
c) Vergleich der Rampenspannung (U_{R}) mit der Referenzspannung (U_{ref}),
d) Erhöhung der Rampenspannung (U_{R}) um eine weitere Spannungsstufe, falls die Rampenspannung (U_{R}) kleiner als die Referenzspannung (U_{ref}) ist und Bestimmung der Anzahl der Spannungsstufen und Durchführung des Schrittes c),
e) Auswertung der Anzahl der Spannungsstufen, falls die Rampenspannung (U_{R}) größer als die Referenzspannung (U_{ref}) ist.

5. Verfahren nach Anspruch 3 oder 4, wobei die Auswertung der Anzahl der Spannungsstufen softwaremäßig mittels eines Mikroprozessors (2) erfolgt.

6. Schaltungsanordnung zur Durchführung des Verfahrens nach einem der Ansprüche 1 bis 5, wobei zur Erzeugung der Rampenspannung (U_{R}) ein taktbarer Rampengenerator (6) und zum Vergleich der Meßgröße (U_{M1}, U_{M2}, U_{M3}) mit der Rampenspannung (U_{R}) jeweils ein Komparator (K1, K2, K3) vorgesehen ist.

7. Schaltungsanordnung nach Anspruch 6, wobei zur Erzeugung der Referenzspannung (U_{ref}) eine Referenzspannungsquelle (6) und zum Vergleich der Referenzspannung (U_{ref}) mit der Rampenspannung (U_{R}) ein Komparator (K4) vorgesehen ist.

8. Schaltungsanordnung nach Anspruch 6 oder 7, wobei zur Ermittlung der Anzahl der Spannungsstufen ein Impulszähler (3) vorgesehen ist.
